(19) Europäisches Patentamt
European Patent Office
Office européen des brevets

(11) **EP 4 625 042 A1**

(12) # EUROPEAN PATENT APPLICATION

(43) Date of publication:
**01.10.2025 Bulletin 2025/40**

(21) Application number: **24305487.1**

(22) Date of filing: **28.03.2024**

(51) International Patent Classification (IPC):
**G03F 7/00** (2006.01)

(52) Cooperative Patent Classification (CPC):
**G03F 7/0002**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Université d'Aix Marseille
13007 Marseille (FR)**
• **Centre National de la Recherche Scientifique
75016 Paris (FR)**

(72) Inventors:
• **GROSSO, David
13012 MARSEILLE (FR)**
• **JOOD, Priyanka
13012 MARSEILLE (FR)**
• **MALGRAS, Victor
13012 MARSEILLE (FR)**

(74) Representative: **IPAZ
16, rue Gaillon
75002 Paris (FR)**

(54) **DIRECT METAL NANOIMPRINT**

(57)    The invention relates to a metal imprinting process, comprising the steps of (a) preparing a solution comprising at least one metal salt that comprises at least one metal cation that can be reduced, a solvent, and optionally at least one complexing or reducing agent; (b) Applying said solution onto a substrate to form a film; (c) Applying a polymeric mold onto said film; (d) Thermally or UV treating the assembly obtained in step c-i) or c-ii); (e) Removing the mold to obtain a substrate coated with a pattern of completely or partially reduced metal, and (f) Curing said pattern so as to obtain a patterned metal on said substrate. The invention also relates to a patterned substrate obtainable by the process of the invention and its use for manufacturing advanced electronics, sensors, and/or optical devices.

### Approach for Negative Patterning

PDMS comes in contact with the Au-salt film

The assembly is heated for minimum 5 min

PDMS lifted after sufficient heating to obtain the Au pattern

### Approach for Positive Patterning

PDMS comes in contact with the Au-salt film — Substrate 1

PDMS lifted within 30 sec — Substrate 1

The same PDMS applied to another substrate and the assembly is heated for minimum 5 min — Substrate 2

PDMS lifted after sufficient heating to obtain the Au pattern — Substrate 2

**Fig. 1**

EP 4 625 042 A1

**Description**

FIELD OF THE INVENTION

The present invention pertains to the field of metal imprinting processes and more specifically to direct metal nanoimprint.

BACKGROUND OF THE INVENTION

The ability to deposit precise patterns of metal on surfaces is essential for the development of advanced electronics, sensors, and optical devices. Metals such as Gold is a popular choice of material for such applications, due to its excellent electrical conductivity, chemical stability, and optical properties. However, conventional methods of direct metal patterning, in particular gold patterning, such as, electron beam lithography and photo-lithography, are limited by their cost, low throughput, scalability, and use of toxic materials. Furthermore, high-throughput methods such as direct laser printing suffers from resolutions limited by the beam size and laser-induced damages.

Therefore, there is a growing need to develop new low-cost and high-throughput nanoimprinting methods to deposit metal patterns, such as gold patterns, on surfaces with high precision and efficiency. However, reduction of metal ions takes place naturally in many solvents through charge exchange, but is generally extremely rapid (instantaneous) or slow (over days or months). Note that a stable ionic suspension undergoing complete reduction will result in precipitation of metal particles in the vial and cannot be further used for imprinting. Therefore, the metal precursor solution must 1) remain stable prior to deposition and imprinting (slow reduction), 2) be undergoing complete reduction through a gentle trigger such as, but not limited to, mild thermal treatment (25-200 °C).

Very few cases of nanoimprinted gold have been reported, and they mostly involve a complex set of steps. For example, nanoimprinting is used to pattern resin or the like for subsequent lift-off process, for a total number of steps between 5 and 8 ("Highly parallel fabrication of nanopatterned surfaces with nanoscale orthogonal biofunctionalization imprint lithography" Nanothechnology 18, 135101 (2007) ; "Large Area Nanoimprinted Colloidal Au Nanocrystal-Based Nanoantennas for Ultrathin Polarizing Plasmonic Metasurfaces" Nano Lett. 15, 5254 (2015)). The limitations also include the complexity involved in the lift-off process: use of high-power excimer lasers, resin pattering, gold/adhesive layer deposition, resin removal using harsh piranha acid solution.

Another approach involves transfer printing, where the patterned mold is first coated with gold, and then pressed on a substrate in order to print the gold to replicate the molded pattern. A high-resolution approach (down to 9 nm) involves as many as 10 steps, but a lower resolution (200 nm) can be achieved by simply evaporating gold on a cyclo-olefin mold, available for subsequent transfer. ('Fabrication of Gold Nanostructures on Quartz Crystal Microbalance Surface Using Nanoimprint Lithography for Sensing Applications' Micromachines 13, 1430 (2022)

To the best of the inventor's knowledge, there is only one report on direct nanoimprinting using hot embossing of Au nanoparticle colloid solution on indium tin oxide (ITO) substrate Fabrication of Gold Nanostructures on Quartz Crystal Microbalance Surface Using Nanoimprint Lithography for Sensing Applications' Micromachines 13, 1430 (2022)).

There is a strong demand for the simplest way of achieving direct metal imprinting, in particular direct Au and Ag nanoimprinting, which would meet the market demands for low-cost, high resolution, and high throughput fabrication.

SUMMARY OF THE INVENTION

The inventors have shown that a direct metal nanoimprinting method which meets the market demands for low-cost, high resolution (down to 20 nm), and high throughput fabrication can be satisfied by preparing a solution of metal precursor(s) comprising at least one metal salt that comprises at least one metal cation that can be reduced, a solvent, and optionally at least one complexing or reducing agent. The process of the invention allows to obtain a metal precursor solution that 1) remains stable prior to deposition and imprinting (slow reduction), 2) is undergoing reduction through a gentle trigger such as mild thermal treatment (25-200 °C).

Besides, the inventors have encountered a technical problem when using a cured PDMS mold for nanoimprint lithography, which is usually the first choice: during imprinting, the PDMS mold sticks to the substrate where the contact between the mold and the metal salt film is made. This results in the tearing of the mold during unmolding process where a major part of the PDMS mold surface remains on the substrate where the final print should be. Without wishing to be bound by any theories, the inventors believe that that is because in the cured (crosslinked) PDMS, there remains some residual Si-H group that can act as the direct reduction reagent to reduce metal salt (in particular Au salt) [Lab Chip, 2008,8, 352-357]. Indeed, the crosslinking of PDMS is based on the reaction between silicon hydride (Si-H) groups in the curing agent and vinyl groups (Si-CH=CH$_2$) in the monomer [Polymers (Basel) 2019, 11(11), 1842].

The inventors have shown that the process of the invention solves this technical problem and allows the PDMS mold to be reused.

A first object of the invention is a metal imprinting process, comprising the successive steps of:

a) Preparing a solution comprising at least one metal salt that comprises at least one metal cation that can be reduced; a solvent; and optionally at least one complexing or reducing agent;

b) Applying said solution onto a substrate to form a film;

c) Applying a polymeric mold onto said film:

    i. To provide an assembly where said film fills up the cavities of the mold; or

    ii. To provide an assembly where said film adheres to the in-contact-surface of the mold, then moving the mold from the first substrate to a second substrate;

d) Thermally treating or UV treating the assembly obtained in step c-i) or c-ii);

e) Removing the mold to obtain a substrate coated with a pattern of completely or partially reduced metal, and

f) Curing said pattern so as to obtain a patterned metal on said substrate.

A second object of the invention is a patterned substrate obtainable by the metal imprinting process according to the invention.

Another object of the invention relates to the use of the patterned substrate according to the invention for manufacturing advanced electronics, sensors, and/or optical devices.

BRIEF DESCRIPTION OF THE FIGURES

Figure 1. Schematic of the two imprinting methods employed to print Au, Direct imprinting (providing a negative print), and contact imprinting (providing a positive print).

Figure 2. Dark field microscope image of the Au crystals organized in (a) square and (b) hexagonal arrays through direct metal imprinting process. The inset of (a) shows the SEM image of the pattern.

Figure 3. Photo of the PDMS molds used for imprinting Au. On the left is the PDMS mold which was treated in UV-Ozone cleaner before imprinting, and on the right is the PDMS mold which was used without UV-Ozone treatment. *

Figure 4. (a) SEM image of the area where PDMS remained attached to the Si substrate after demolding. (b) EDX line scan revealing the presence of Si, O, and C, beside Au, in the lighter contrast area, which comes from the PDMS residue left behind after demolding.

Figure 5. Optical microscope (a) bright-field and (b) dark-field image (100× magnification) of pillar array of Au: PVP complex with pillar size of 400 nm and distance between pillars of 880 nm.

Figure 6. SEM images of the pillar arrays of (a) Au: PVP complex annealed at 300 °C and (b) PVP removed pure Au obtained after annealing at 500 °C for 15 min.

Figure 7. SEM images of grid arrays with (a) line-width (W) of 140 nm and pitch (P) of 175 nm, and (b) W of 160 nm and P of 800 nm. Dark field microscope image in grey scale of grid arrays with varying W and P (c) parallel and (d) perpendicular to the polarized light. (e) The W and P of each array shown in (c) and (d). The maximum value of degree of polarization (DOP) was obtained for the array with W= 140 nm and P = 175 nm.

Figure 8. Dark field microscope images of the hexagonal array pattern of (a) Ag-Ammonia complex annealed at 200 °C and (b) pure Ag made of reduced Ag nanoparticles obtained after annealing at 350 °C for 15 min.

Figure 9. (a) Dark field microscope image and (b) SEM image of the mesh-like Au pattern comprising of Au nanoparticles, obtained using contact transfer printing.

DETAILED DESCRIPTION OF THE INVENTION

The invention relates to a metal imprinting process, comprising the successive steps of

a) Preparing a solution comprising at least one metal salt that comprises at least one metal cation that can be reduced; a solvent; and optionally at least one complexing or reducing agent;

b) Applying said solution onto a substrate to form a film;

c) Applying a polymeric mold onto said film:

    i. To provide an assembly where said film fills up the cavities of the mold; or

    ii. To provide an assembly where said film adheres to the in-contact-surface of the mold, then moving the mold from the first substrate to a second substrate;

d) Thermally or UV treating the assembly obtained in step c-i) or c-ii);

e) Removing the mold to obtain a substrate coated with a pattern of completely or partially reduced metal, and

f) Curing said pattern so as to obtain a patterned metal on said substrate.

The process according to the invention comprises a first step a) of preparing a solution comprising a solvent, and at least one metal salt that comprises at least one metal cation that can be reduced. Said solution optionally comprises at least one complexing or reducing agent.

The expression "metal cation that can be reduced" refers to any metal cations that undergoes a reduction reaction, in particular during a treatment such as heat treatment or UV treatment. The reduction process involves the exchange of charges between the cation and the solvent and/or other reducing agents. Such reaction is controlled to be slow in order to maintain the stability of the solution prior to molding. The treatment (such as heat treatment or UV treatment) brings the necessary energy to accelerate this mechanism and trigger "rigidification". The metal cation that can be reduced may for instance be selected from the group consisting of gold (Au) cations, silver (Ag) cations, platinum (Pt) cations, copper (Cu) cations, iron (Fe) cations, cerium (Ce) cations, palladium (Pd) cations, aluminum (Al) cations, nickel (Ni) cations, and zinc (Zn) cations. In the context of the invention, the metal cation that can be reduced is preferably selected from the group consisting of Au cations, Ag cations and Pt cations.

In particular, the metal cation that can be reduced is preferably selected from the group consisting of $Au^+$, $Au^{2+}$, $Au^{3+}$, $Au^{4+}$, $Ag^+$, $Ag^{2+}$, $Ag^{3+}$, $Pt^+$, $Pt^{2+}$, $Pt^{3+}$ and $Pt^{4+}$, more preferably selected from the group consisting of $Au^+$, $Au^{2+}$, $Au^{3+}$, $Au^{4+}$, $Ag^+$, $Ag^{2+}$, and $Ag^{3+}$, even more preferably selected from the group consisting of $Au^+$, $Au^{2+}$, $Au^{3+}$ and $Au^{4+}$.

In the context of the invention, the metal salt can be an inorganic salt or organics salt that comprise a metal cation as defined above. Examples of inorganic salts are halides (fluorides, chlorides, bromides or iodides, especially chlorides), oxychlorides, sulfate, and nitrates. Examples of organic salts are oxalates and acetates.

In the context of the invention, the anionic group of the metal salt is preferably selected from the group consisting of chloride ($Cl^-$), nitrate ($NO^{3-}$), sulfate ($SO_4^{2-}$), acetate ($C_2H_3O^{2-}$), and acetylacetonate.

In a specific embodiment of the invention, the metal salt is selected from the group consisting of $HAuCl_4.3H_2O$, $HAuCl_4.xH_2O$, $HAuCl_4$, $AuCl_3$, $Au(OH)_3$, $AuCl$, $AgNO_3$, $AgCl$, and $CH_3COOAg$.

The molarity of metal salt in the metal-salt solution can be from 0.02 M to 5 M, preferably from 0.05M to 2M.

In the context of the invention, the solution prepared in step a) comprises a solvent. For example, the solvent can be selected from water, mono- or dihydric alcohols, such as methanol, ethanol, n-propanol, isopropanol, acetone, tetrahydrofuran (THF), hexane, toluene, ethylene glycol, propylene glycol or mixtures thereof. Water combined with organic solvent(s) can also be used.

In a specific embodiment, the solution prepared in step a) comprises a solvent selected from the group consisting of water, ethanol, isopropanol, acetone, tetrahydrofuran (THF), hexane, toluene, and mixtures thereof. Preferably, the solvent is ethanol in order to improve the wetting of the substrate, disperse the precursors and reduce the toxicity of the process.

In a specific embodiment of the invention, the solution prepared in step a) further comprises at least one complexing or reducing agent.

In the context of the invention, a "reducing agent" refers to any substances that reduces a metal cation by donating electrons. For example, the reducing agent can be selected from the group consisting of alcohols (such as ethanol, methanol, isopropanol, propanol, butanol, pentanol, hexanol, and mixtures thereof), sugars, ascorbic acid, oxalic acid, $NaBH_4$, hydrazine hydrate, and mixtures thereof.

The amount of reducing agent in the metal-salt solution can be from 0 M to 50 mM, preferably from 0 M to 2 mM.

In the context of the invention, a "complexing agent" refers to any substances that is capable of forming a complex with a metal cation in the solution. For example, the complexing agent can be selected from the group consisting of vinyl-, amine-, thiol-, carboxylic-, acetate-, ammonium-, sulfur- and alcohol-terminated compounds and mixtures thereof.

Preferably, the complexing agent can be selected from the group consisting of polyvinylpyrrolidone (PVP), citric acid, oleylamine, ammonia, urea, and mixtures thereof.

More preferably, PVP is used as a complexing agent when the metal cations is Au or Ag cations. It provides easier control of the reduction process by stabilizing the metal cations in the solution and promoting the reduction only during the heating step. Moreover, PVP enhances the wettability of the Au-salt solution on the substrate and contributes to achieving homogeneity.

The molarity of complexing agent in the metal-salt solution can be from 0 M to 50 mM, preferably from 0 M to 2 mM.

The solution may additionally comprise a catalyst, which may be selected from basic catalysts (such as $NH_3$) and acidic catalysts, preferably a small and volatile acid (such as acetic acid or hydrochloric acid), less preferably a non-volatile acid (such as nitric acid). It may further comprise one or more polymers, intended for instance to form mesopores in the metal film to improve its homogeneity, such as amphiphilic block copolymers.

The process according to the invention comprises a second step b) of applying the solution prepared in step a) onto a first substrate to form a film.

The solution may be applied to the first substrate by any appropriate means, including dip-coating, spin-coating or spray-coating, but preferably by dip-coating. In particular, the solution is applied to the substrate so as to form a layer having a thickness of from 5 nm to several microns, preferably from 20 to 200 nm. Preferably, step b) is carried out at relative humidity of at least 30%. The substrate onto which the metal salt film is deposited may be for instance selected from glass, metal or polymeric substrates. Examples of polymers that may be used in the substrate include polyimide, polycarbonate and polyester (such as polymethyl methacrylate) substrates. The film thickness may be adjusted by controlling the deposition conditions (dip-coating withdrawal rate; spin-coating revolution rate) and the solution viscosity and concentration.

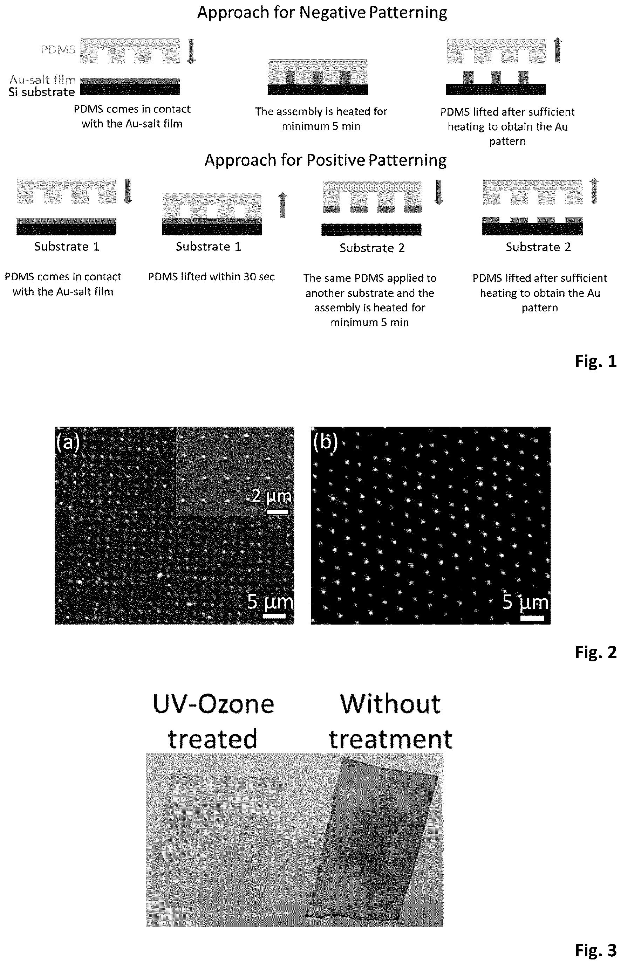

The process according to the invention then comprises a third step c) of applying a polymeric mold onto said film. For step c), two methods can be used depending on whether a negative or positive print is sought. Figure 1 shows a schematic of the two imprinting methods employed to print Au as an example.

The first method (step c-i)) is to provide an assembly where the film obtained in step b) fills up the cavities of the mold. Said method, also called direct imprinting method, is used to obtained a negative print.

The second method (step c-ii)) is to provide an assembly where the film obtained in step b) adheres to the in-contact-surface of the mold, and then the mold is moved from the first substrate to a second substrate. Said method, also called contact printing method, is used to obtained a positive print. Typically, the mold can be kept onto the film obtained in step b) only for a few seconds so that the film adheres to the in-contact-surface of the mold; the mold is then removed from the first substrate and placed on a second substrate to obtained the assembly. In this context, the second substrate may be made of the same or a different material to the first substrate. For example, the second substrate may be selected from glass, metal or polymeric substrates.

The polymeric mold is typically obtained as a negative copy from a master template. The master template itself may be firstly fabricated from silicon or any other suitable material such as glass, metal oxide(s), polymers, hybrid materials and composite materials. It may be manufactured by electron beam lithography (EBL), Focused Ion Beam lithography (FIB) or any other suitable patterning technology. Then, the surface of the master may be treated to form an anti-adhesive layer thereon. The liquid mold material may then be spin coated or casted into the master template to duplicate a patterning layer. The material is usually degassed in a low-pressure vacuum chamber. Subsequently, a backplane or a flexible layer may be bonded to the patterned layer. Thermal or UV curing is then generally performed in order to reduce roughness and to avoid a build-up of tension because of thermal shrinkage. The replicated mold is left to cool to room temperature and carefully peeled off from the master template.

Typically, the polymeric mold can replicate the patterns from the master template with a resolution down to 20 nm.

According to a preferred embodiment of this invention, the mold is degassed before demolding from the master template, for instance in a pumped desiccator.

Examples of materials that may be used for the manufacture of the mold are silicone elastomers (crosslinked polysiloxanes) that may be obtained by mixing a polysiloxane bearing reactive (such as hydride or vinyl) groups with a crosslinking silicone oligomer. Such molds are usually referred to as "PDMS molds". Other materials that may be used for the manufacture of the soft mold are fluorinated polymers, such as perfluoropolyether (PFPE) and its derivatives, including HPFPE which is a copolymer resin of a perfluoropolyether (PFPE) and a hyperbranched polymer (HP), acryloxy PFPE (denoted as a-PFPE) or a-,w-methacryloxy functionalized PFPE (PFPE-DMA); and tetrafluoroethylene and its derivatives, including ETFE (which is a copolymer of ethylene and tetrafluoroethylene) and copolymers of 2,2-bistrifluoromethyl- 4,5-difluoro-1,3-dioxole and tetrafluoroethylene. Other suitable materials may be selected from polyvinylpyrrolidone (PVP), polylactic acid (PLA) and polyetherimide (PEI), for instance.

In the context of the invention, the polymeric mold is preferably an elastomeric mold, more preferably a mold manufactured from silicone elastomers.

In a specific embodiment, the polymeric mold is preferably a polydimethylsiloxane (PDMS) mold. In that context, the PDMS used for forming the mold can be subjected to surface modification, such as UV-Ozone or oxygen plasma treatment, prior to its use as a mold, in order to oxidize the Si-H groups (i.e., the reducing agent) at the surface of the mold, and thus to circumvent the problem of PDMS adhering to the film. For example, the PDMS mold can be submitted to a 20-minute treatment in a UV-Ozone cleaner. This treatment made the Si-H group in PDMS in such a low content that metal reduction and adhesion at the surface of the PDMS become negligible.

As an alternative to mold surface modification, the use of complexing agents such as, but not limited to, PVP can be sufficient to limit the interactions between the Si-H groups from the PDMS surface and the metal cation.

In the context of the invention, the surface of the mold is considered to be any surfaces that will be in contact with the metal salt solution. The surface of the mold can be the total surface of the mold.

In a specific embodiment of the invention, the step c) of applying the mold onto the film can be performed under solvent vapor. In particular, the mold can typically be degassed a few minutes before the replication step so that its porosity is empty enough to act as a "sponge" which pumps the solvent contained into the metal-salt film while the metal-salt solution is sucked inside the protrusions of the mold. Specifically, according to a preferred embodiment of this invention, the pressure applied to the mold during step c) described above that of the weight of the mold only (i.e. typically less than 10 $g/cm^2$), so as to limit short-range deformations in the nanostructures formed from the film.

In order to reach the above uptake values, a calibration step can be performed before conducting the process of this invention. For example, the film can be deposited on the substrate as described before, and placed in a chamber supplied with a dry air flow or a mixed flow of air and solvent. The solvent can be a volatile solvent that may be selected from water, ethanol, isopropanol, acetone, THF, hexane, toluene and any other suitable solvent. The solvent relative pressure can be varied by changing the relative flow rates of dry air and air/solvent ($P/P_o = 1$) and the volume of the film is measured for each value of the relative pressure by any appropriate means, such as by ellipsometry. A curve can thus be plotted, which may be used while conducting the process of the invention to determine the solvent relative pressure that should be applied during the replication step c).

Importantly, the process of the invention can be conducted, until this point, under mild pressure and temperature conditions, especially ambient pressure and temperature.

In the next step d) of the process according to the invention, the assembly formed by the mold and the coated substrate is then submitted to a heat treatment or a ultraviolet treatment (UV treatment). Typically, the heat or UV treatment is carried out so as to rigidify the film and partially or completely reduce the metal cation. By "partially or completely reduce" it is meant that the metal cation is totally reduced or that part of the metal cation is reduced while the other part remains as such. The duration and conditions of the heat treatment (such as temperature) or the UV treatment (such as intensity or wavelength) may be adjusted to any suitable range for obtaining a film which displays preference adherence to the substrate compared to the mold and sufficient rigidification to avoid collapsing of the pattern after unmolding. Depending on the constituents of the metal salt solution prepared in step a), a heat treatment may for instance be performed at a temperature of from 25 to 200°C, for typically between 1 to 10 minutes. Step d) also allows the evaporation of part of the solvent present in the film, further promoting its rigidification. Finally, step d) allows the partial or complete reduction of the metal cations present in the metal salt solution prepared in step a).

In a specific embodiment, step d) is a heat treatment, where the reduction of the metal and the rigidification of the patterned film can be carried out through heat treatment.

In another specific embodiment, step d) is a UV treatment, where the metal precursor or the complexing agent are UV sensitive and the rigidification of the patterned film can be carried out through exposing the film to UV light.

The mold is then removed in step e) to obtain a substrate coated with a patterned metal. Typically, the patterned metal may have started to solidify and reduce and this metal is further densified by curing so as to obtain a patterned metal material on said substrate.

Typically, the curing (or annealing) step (f) results in (i) a complete removal of the solvent present in the colloidal solution, of the solvent absorbed by the film and of the organic by-products generated by the precursors and of the polymer(s) that may be present in the metal-salt solution; and/or (ii) a complete metal reduction; and/or (iii) a sintering of the reduced metal particles.

The duration and temperature of the curing treatment f) may be adjusted to any suitable range, depending on the constituents of the solution, so as to obtain constant dimensions of the pattern and for instance from 200 to 800°C.

The obtained patterned metal material on said substrate may be subjected to any further chemical and/or physical treatment aiming at modifying the nature of the metal.

In a particular embodiment, the process according to the invention comprises a step (a') of converting the metal precursors into a metal suspension after step (a) and before step (b. Such process comprises the successive steps of

a) preparing the solution comprising at least one metal salt that comprises at least one metal cation that can be reduced, a solvent, and optionally at least one complexing or reducing agent,
a') converting said metal salt into a metal suspension in solution,
b) applying said solution onto a first substrate to form a film,
c) Applying a polymeric mold onto said film:

i. To provide an assembly where said film fills up the cavities of the mold;
or
ii. To provide an assembly where said film adheres to the in-contact-surface of the mold, then moving the mold from the first substrate to a second substrate;

d) thermally or UV treating said assembly, and
e) Removing the mold to obtain a substrate coated with a pattern of completely or partially reduced metal,
f) optionally curing said pattern so as to obtain a patterned metal on said substrate.

The duration and temperature of step (a') may be adjusted to any suitable range, depending on the constituents of the colloidal solution. Step (a') may be carried out at room temperature. Step (a') may also be carried out under hydrothermal conditions.

In this context, the solution of step a) may also comprise surfactants, such as a cationic surfactant, to stabilize the colloidal solution. Chelating agents may further be provided in said solution.

The method of the invention allows to obtain micro or nano metallic pattern. Typically the method allows to obtain a metallic pattern with lateral size down to 20 nm.

The patterned substrate thus obtained may be used in various applications and in particular for manufacturing advanced electronics, sensors, and optical devices. Among such applications, mention can be made of, for instance, polarizers, transparent conducting substrates, surface enhanced Raman spectroscopy platforms.

Therefore, a second object of the invention is a patterned substrate obtainable by the metal imprinting process according to the invention.

Another object of the invention relates to the use of the patterned substrate according to the invention for manufacturing advanced electronics, sensors, and/or optical devices.

EXAMPLES

This invention will be better understood in light of the following examples which are given for illustrative purposes only and do not intend to limit the scope of the invention, which is defined by the attached claims.

Example 1: Direct nano-imprinting applied to Au (providing a negative print)

An Au salt solution was made by mixing 0.3 g of Gold(III) chloride trihydrate $HAuCl_4.xH_2O$ and 14 g of ethanol under ambient conditions.

A surface modified PDMS mold was used which was obtained by subjecting the PDMS mold to a UV-ozone treatment. Precisely, the PDMS mold underwent a 20-minute treatment in a UV-Ozone cleaner, effectively oxidizing the Si-H groups on the PDMS surface. This treatment made the Si-H group in PDMS non-available for Au reduction.

The following direct nano-imprinting method was then employed for imprinting Au (see Figure 1): A silicon substrate was dip-coated with the Au salt solution, utilizing a dip-coating speed of 2 mm/s. Following the dip-coating process, the substrate was positioned on a hot plate at 30°C, and subsequently, a UV-Ozone-treated PDMS mold was applied to the film to provide an assembly such that said film fills up the cavities of the mold. The entire assembly was then heated to 80 °C for 5 minutes, which includes a 1-minute ramp-up to reach the 80 °C temperature, during which the solvent and other volatile species are partially or fully evaporated. After the assembly had cooled down, the PDMS mold was carefully removed, and the whole system underwent further heating at 300 °C for 10 minutes to ensure complete Au reduction and removal of byproducts.

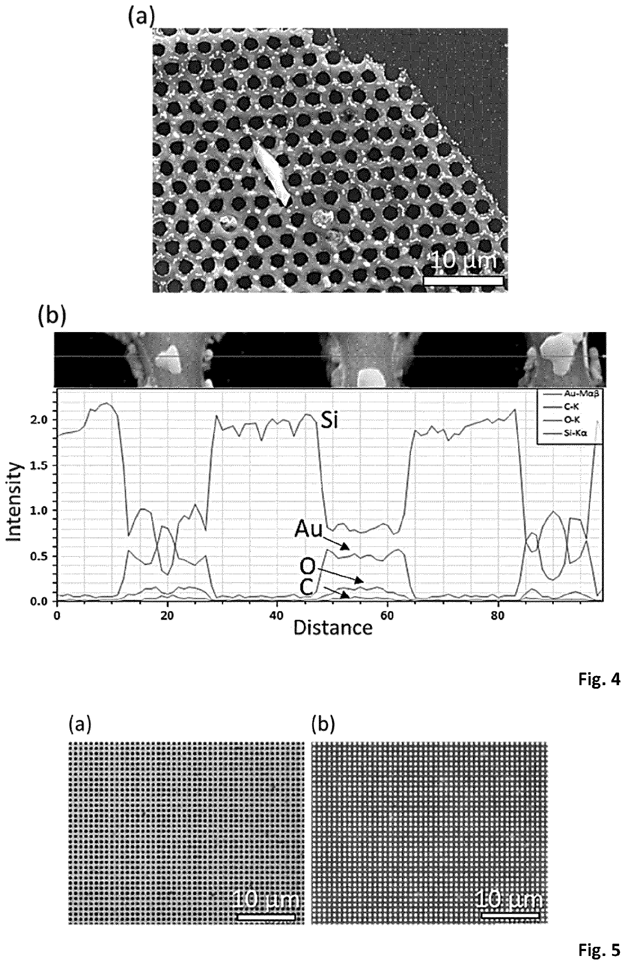

The imprinted Au metal patterns organized in square and hexagonal array obtained through this process are shown in Figure 2 as an optical microscope image in dark field. The inset of Figure 2a shows the SEM image of the pattern. The intended applications for these gold (Au) nanopatterns are focused on leveraging surface plasmon resonance (LSPR), leading to enhanced light-matter interactions, which are beneficial, but not limited to, techniques like surface-enhanced Raman spectroscopy (SERS). Remarks: The Au-salt solution of example 1 is free of complexing or reducing agent. Therefore, when an untreated PDMS mold was applied to the substrate coated with the Au-salt solution (without complexing agent), a pink discoloration in the PDMS occurred. Figure 3 displays a photograph of two PDMS samples employed in the imprinting of Au. The left side exhibits the UV-Ozone treated PDMS, which shows no signs of breakage or discoloration following its use as a mold for Au nanoimprinting. In contrast, the PDMS on the right has a roughened surface and discoloration, attributed to an unintended reaction with Au-salt and adhesion to the substrate during the imprinting process. Furthermore, during the demolding process, the PDMS adhered to the substrate, resulting in tearing and leaving behind a distinct residue at the points of contact with the film. The SEM image in Figure 4a shows the area where PDMS remained attached to the Si substrate after demolding. The EDX line mapping in Figure 4b confirms that the lighter contrast area comprises of PDMS adhering to the Au pattern, as it contains Si, O, and C, along with Au. The dark contrast area is Si substrate. The light contrast nanoparticles seen inside the PDMS are confirmed as Au nanoparticles which are formed when the anions $AuCl_4^-$ slowly diffuse into the inside of the PDMS and react with the residual Si-H groups which are acting as reducing agent. This is why the UV-Ozone treatment of PDMS mold is preferable while imprinting complexing agent-free solutions.

**Example 2: Direct nano-imprinting applied to Au (with complexing agent)**

The solution was prepared by mixing 0.3 g of $HAuCl_4.xH_2O$, 0.04 g PVP (Polyvinylpyrrolidone, $(C_6H_9NO)_n$, $M_w \sim 29,000$), 1 g deionized water, and 8 g absolute ethanol. The solution was dip-coated on silicon substrate at a dip coating speed of 5 mm s$^{-1}$. After dip-coating, PDMS mold was readily applied on the as-deposited Au salt:PVP film. This assembly was cured at 70 °C for 5 min followed by unmolding. Finally, the substrate containing the Au-salt:PVP patterns is annealed at temperature 500-550 °C for 15 min for PVP to be completely removed from the print. Here, direct imprinting method was utilized (see Example 1 and Figure 1).

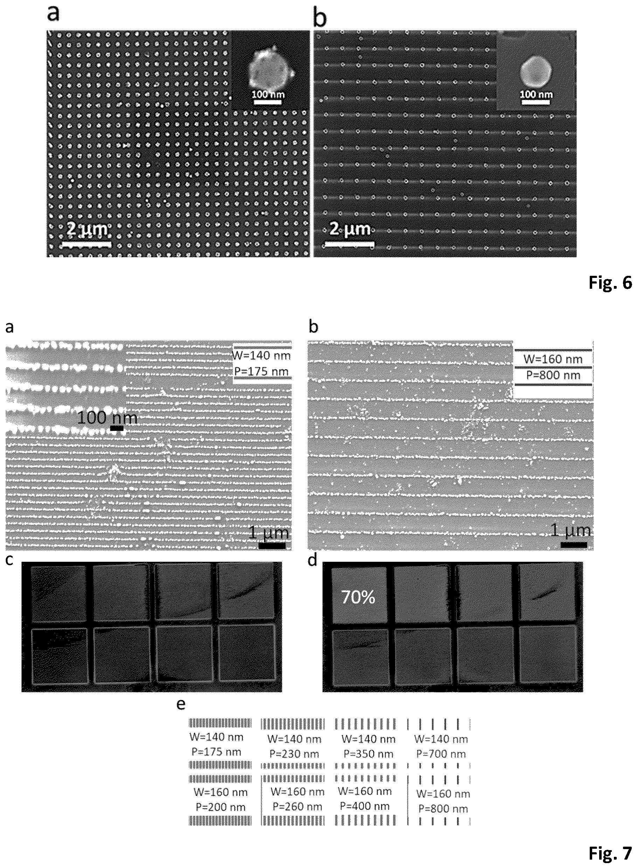

Figure 5 shows the microscope image in bright field (a) and dark field (b) of the Au salt: PVP solution imprinted via direct imprinting method annealed at 300 °C, where the solvent has been removed but PVP still remains in the patterns. These images illustrate the homogeneity and predominantly defect-free nature of the pattern. Scanning electron microscopy (SEM) images of the fabricated array of pillars show Au salt: PVP pillars organized in a regular square array are shown in Figure 6a. One can observe the small grains (less than 20 nm in size) composing the pillars. It should be noted that there is no 2D residual layer underneath. Upon annealing the sample at 500 °C, the PVP is eliminated, resulting in pure Au pillars that exhibit faceted and single-crystalline characteristics (Figure 6b).

As another example, line grids of Au with different line-width and inter-distance were patterned using the same method described above. The lines are made of Au nanoparticles with dimensions typically between 40 to 100 nm (Figure 7a and 7b). To demonstrate an application as a polarizer a preliminary test was performed where arrays with line-width of 140 and 160 nm, and inter-distance of 175-800 nm were observed under the microscope in dark-field with a polarizer installed. Figure 7c and 7d show a clear contrast between image taken parallel or perpendicular to the polarized light. The polarization of light can be described quantitatively by the degree of polarization (DOP) which is calculated using the following equation:

$$DOP = \frac{I_\perp - I_\parallel}{I_\perp + I_\parallel},$$

where $I_\perp$ and $I_\parallel$ are the intensity of light perpendicular and parallel to the polarizer, respectively.

The maximum degree of polarization (DOP) achieved in our preliminary experiments was 70% for arrays with line-width of 140 nm and inter-distance of 175 nm.

**Example 3: Direct imprinting applied to Ag**

The solution was prepared by mixing 0.5 g of AgNO$_3$, 1 g deionized water, and 8 g absolute ethanol with vigorous stirring until all the AgNOs was dissolved. Then, 0.7 g of Ammonia 32% was added dropwise until a clear transparent solution is obtained which indicates the formation of a soluble complex of Ag and ammonia. The solution was dip-coated on silicon substrate at a dip coating speed of 5 mm s$^{-1}$. After dip-coating, PDMS mold was readily applied on the as-deposited Ag-ammonia complex film. This assembly was cured at 70 °C for 5 min followed by unmolding. Finally, the substrate containing the Ag-ammonia complex patterns was annealed at temperature of 350 °C for 15 min for complete removal of byproducts and complete reduction of Ag. Here, direct imprinting method was utilized (see Example 1 and Figure 1).

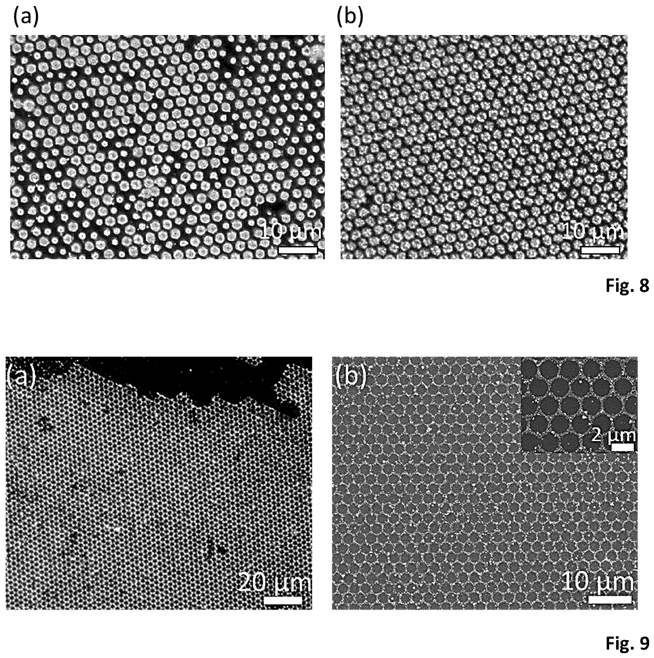

Figure 8 shows the dark field Microscope images of Si substrate consisting of a hexagonal array pattern of Ag-ammonia complex annealed at 200 °C and then at 350 °C. It can be seen that contrary to (a), the patterns in (b) are made of reduced Ag nanoparticles. This is indicative of the highly controlled temperature induced reduction of Ag within well-defined patterns facilitated by the use of a complexing agent.

**Example 4: Contact imprinting applied to Au (providing a positive print)**

A silicon substrate was dip-coated with the Au salt solution obtained in example 1, utilizing a dip-coating speed of 2 mm/s. Shortly after the dip-coating process, the substrate was transferred to a hot plate set at 30°C, and a UV-ozone treated PDMS mold was promptly applied to the film. The UV-ozone treated PDMS mold was removed within 30 seconds and applied to another silicon substrate. The assembly was then heated to 80 °C for 5 minutes, followed by cooling and subsequent removal of the UV-ozone treated PDMS mold. To complete the reduction process and eliminate solvents entirely, the substrate was subjected to further heating at 300 °C for 10 minutes. Figure 9a shows the Microscope image in dark field and Figure 9b shows an SEM image of the mesh-like Au pattern obtained using contact printing. The mesh structure allows for electrical conductivity while maintaining certain transparency properties. This is useful in various electronic and optoelectronic applications utilizing transparent conductive films.

**Claims**

1. A metal imprinting process, comprising the successive steps of

   a) Preparing a solution comprising a solvent, and at least one metal salt that comprises at least one metal cation that can be reduced;
   b) Applying said solution onto a substrate to form a film;
   c) Applying a polymeric mold onto said film:

      i. To provide an assembly where said film fills up the cavities of the mold; or
      ii. To provide an assembly where said film adheres to the in-contact-surface of the mold, then moving the mold from the first substrate to a second substrate;

   d) Thermally or UV treating the assembly obtained in step c-i) or c-ii);
   e) Removing the mold to obtain a substrate coated with a pattern of completely or partially reduced metal, and
   f) Curing said pattern so as to obtain a patterned metal on said substrate.

2. The process according to claim 1, wherein the metal cation is selected from the group consisting of gold (Au) cations, silver (Ag) cations, platinum (Pt) cations, copper (Cu) cations, iron (Fe) cations, cerium (Ce) cations, palladium (Pd) cations, aluminum (Al) cations, nickel (Ni) cations, and zinc (Zn) cations, preferably of Au cations and Ag cations.

3. The process according to claim 1 or 2, wherein the anionic group of the metal salt is selected from the group consisting of chloride (Cl$^-$), nitrate (NO$^{3-}$), sulfate (SO$_4^{2-}$), acetate (C$_2$H$_3$O$^{2-}$), and acetylacetonate.

4. The process according to any one of claims 1 to 3, wherein the solution of step a) comprises at least one complexing or reducing agent.

5. The process according to claim 4, wherein the complexing or reducing agent is selected from the group consisting of vinyl-, amine-, thiol-, carboxylic-, acetate-, ammonium-terminated compounds, alcohols, sugars, ascorbic acid, oxalic acid, $NaBH_4$, hydrazine hydrate and mixtures thereof.

6. The process according to claim 4 or 5, wherein the metal cation is an Au cation, and the complexing agent is selected from the group consisting of vinyl-terminated compounds such as polyvinylpyrrolidone (PVP), and/or the reducing agent is selected from the group of alcohols such as ethanol, methanol, isopropanol, propanol, butanol, pentanol, hexanol, and mixtures thereof.

7. The process according to any one of claims 4 to 6, wherein the metal cation is an Ag cation and the complexing or reducing agent is selected from the group consisting of ammonia.

8. The process according to any one of claims 1 to 7, wherein the polymeric mold is an elastomeric mold, preferably silicone elastomeric mold.

9. The process according to any one of claims 1 to 8, wherein the mold is a polydimethylsiloxane (PDMS) mold.

10. The process according to any one of claims 1 to 9, wherein the mold is a PDMS mold in which the PDMS used has been subjected to surface modification, such as UV-Ozone or oxygen plasma treatment.

11. The process according to any one of claims 1 to 10, wherein step d) is a thermal treatment of the assembly obtained in step c-i) or c-ii).

12. The process according to claim 11, wherein the thermal treatment of step d) is performed at a temperature of from 25 to 200°C.

13. The process according to any one of claims 1 to 12, wherein the curing step f) is performed at a temperature of from 200 to 800°C.

14. A patterned substrate obtainable by the process as defined in any one of claims 1 to 13.

15. Use of the patterned substrate according to claim 14 for manufacturing advanced electronics, sensors, and/or optical devices.

## Approach for Negative Patterning

PDMS comes in contact
with the Au-salt film

The assembly is heated for
minimum 5 min

PDMS lifted after sufficient
heating to obtain the Au
pattern

## Approach for Positive Patterning

Substrate 1

Substrate 1

Substrate 2

Substrate 2

PDMS comes in contact
with the Au-salt film

PDMS lifted within 30 sec

The same PDMS applied to
another substrate and the
assembly is heated for
minimum 5 min

PDMS lifted after sufficient
heating to obtain the Au
pattern

**Fig. 1**

**Fig. 2**

UV-Ozone
treated

Without
treatment

**Fig. 3**

(a)

(b)

Fig. 4

(a)

(b)

Fig. 5

a

b

100 nm

100 nm

2 µm

2 µm

Fig. 6

a

b

W=140 nm
P=175 nm

W=160 nm
P=800 nm

100 nm

1 µm

1 µm

c

d

70%

e

| W=140 nm | W=140 nm | W=140 nm | W=140 nm |
| P=175 nm | P=230 nm | P=350 nm | P=700 nm |

| W=160 nm | W=160 nm | W=160 nm | W=160 nm |
| P=200 nm | P=260 nm | P=400 nm | P=800 nm |

Fig. 7

(a)

(b)

**Fig. 8**

(a)

(b)

**Fig. 9**

Europäisches
Patentamt

European
Patent Office

Office européen
des brevets

# EUROPEAN SEARCH REPORT

**Application Number**

EP 24 30 5487

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/038951 A1 (MIYAKE HIROTO [JP]) 1 February 2024 (2024-02-01) | 14,15 | INV.<br>G03F7/00 |
| A | * abstract *<br>* figures 5,6 *<br>* paragraphs [0001], [0012] - [0014], [0040], [0045], [0075] - [0089], [0112] * | 1-13 | |
| X | JP 2004 006790 A (KRI INC) 8 January 2004 (2004-01-08) | 14,15 | |
| A | * abstract *<br>* figure 1 *<br>* paragraphs [0001], [0003], [0044], [0053] - [0068] * | 1-13 | |
| X | KR 2019 0024358 A (KOREA ADVANCED INST SCI & TECH [KR]) 8 March 2019 (2019-03-08) | 14,15 | |
| A | * abstract *<br>* figures 1,2 *<br>* paragraphs [0001], [0027] - [0047] * | 1-13 | TECHNICAL FIELDS SEARCHED (IPC) |
| X | CN 204 077 025 U (CHENGFENG INTELLIGENT CO LTD) 7 January 2015 (2015-01-07) | 14,15 | G03F |
| A | * abstract *<br>* figure 2 * | 1-13 | |
| X | YOUNGBO CHOI ET AL: "A combined top-down/bottom-up approach to structuring multi-sensing zones on a thin film and the application to SPR sensors", NANOTECHNOLOGY, INSTITUTE OF PHYSICS PUBLISHING, BRISTOL, GB, vol. 27, no. 34, 15 July 2016 (2016-07-15), page 345302, XP020307658, ISSN: 0957-4484, DOI: 10.1088/0957-4484/27/34/345302 [retrieved on 2016-07-15] | 14,15 | |
| A | * the whole document * | 1-13 | |

-/--

The present search report has been drawn up for all claims

| Place of search | Date of completion of the search | Examiner |
|---|---|---|
| Munich | 20 September 2024 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 24 30 5487

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (IPC) |
| X | KR 2012 0097837 A (KOREA ADVANCED INST SCI & TECH [KR]) 5 September 2012 (2012-09-05) | 14,15 | |
| A | * abstract * * figure 1 * | 1-13 | |
| X | US 2018/292311 A1 (BOAMFA MARIUS IOSIF [NL] ET AL) 11 October 2018 (2018-10-11) | 14,15 | |
| A | * abstract * * figures 1,6 * * paragraphs [0002], [0003], [0052] - [0072], [0092] * | 1-13 | |
| X | SABELLA S ET AL: "Room-temperature metal stamping by microfluidics", MATERIALS LETTERS, ELSEVIER, AMSTERDAM, NL, vol. 64, no. 1, 15 January 2010 (2010-01-15), pages 41-44, XP026745579, ISSN: 0167-577X, DOI: 10.1016/J.MATLET.2009.09.066 [retrieved on 2009-10-08] | 14 | |
| | | | **TECHNICAL FIELDS SEARCHED (IPC)** |
| A | * the whole document * | 1-13,15 | |

The present search report has been drawn up for all claims

| Place of search | Date of completion of the search | Examiner |
|---|---|---|
| Munich | 20 September 2024 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................
& : member of the same patent family, corresponding document

# EP 4 625 042 A1

## ANNEX TO THE EUROPEAN SEARCH REPORT
## ON EUROPEAN PATENT APPLICATION NO.

EP 24 30 5487

20-09-2024

| Patent document cited in search report | Publication date | Patent family member(s) | Publication date |
|---|---|---|---|
| US 2024038951 A1 | 01-02-2024 | CN 115956289 A | 11-04-2023 |
| | | EP 4213196 A1 | 19-07-2023 |
| | | JP WO2022050354 A1 | 10-03-2022 |
| | | KR 20230062614 A | 09-05-2023 |
| | | TW 202224212 A | 16-06-2022 |
| | | US 2024038951 A1 | 01-02-2024 |
| | | WO 2022050354 A1 | 10-03-2022 |
| JP 2004006790 A | 08-01-2004 | JP 4445711 B2 | 07-04-2010 |
| | | JP 2004006790 A | 08-01-2004 |
| KR 20190024358 A | 08-03-2019 | NONE | |
| CN 204077025 U | 07-01-2015 | NONE | |
| KR 20120097837 A | 05-09-2012 | NONE | |
| US 2018292311 A1 | 11-10-2018 | CN 108431664 A | 21-08-2018 |
| | | EP 3394657 A1 | 31-10-2018 |
| | | JP 7041618 B2 | 24-03-2022 |
| | | JP 7041618 B6 | 31-05-2022 |
| | | JP 2019505824 A | 28-02-2019 |
| | | JP 2022066214 A | 28-04-2022 |
| | | RU 2018126775 A | 28-01-2020 |
| | | US 2018292311 A1 | 11-10-2018 |
| | | WO 2017109057 A1 | 29-06-2017 |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Highly parallel fabrication of nanopatterned surfaces with nanoscale orthogonal biofunctionalization imprint lithography. *Nanothechnology*, 2007, vol. 18, 135101
- Large Area Nanoimprinted Colloidal Au Nanocrystal-Based Nanoantennas for Ultrathin Polarizing Plasmonic Metasurfaces. *Nano Lett.*, 2015, vol. 15, 5254

- Fabrication of Gold Nanostructures on Quartz Crystal Microbalance Surface Using Nanoimprint Lithography for Sensing Applications. *Micromachines*, 2022, vol. 13, 1430
- *Lab Chip*, 2008, vol. 8, 352-357
- *Polymers (Basel)*, 2019, vol. 11 (11), 1842